# FASCICULE DE BREVET EUROPEEN

(11) **EP 0 797 252 B1**
(45) Date de publication et mention de la délivrance du brevet: **21.05.2008**
(21) Numéro de dépôt: 97400602.5
(22) Date de dépôt: 18.03.1997
(51) Int. Cl.: H01L 21/762, H01L 21/84

(54) **Substrat de type silicium sur isolant pour la fabrication de transistors et procédé de préparation d'un tel substrat**
Silizium auf Isolator-Substrat zum Herstellen von Transistoren und Verfahren zum Vorbereiten eines derartigen Substrats
Silicon on insulator substrate for fabricating transistors and method for preparing such a substrate

(30) Priorité: 20.03.1996 FR 9603448
(43) Date de publication de la demande: 24.09.1997
(73) Titulaire: COMMISSARIAT A L'ENERGIE ATOMIQUE, 75015 Paris (FR)
(72) Inventeur: Deleonibus, Simon, 38640 Claix (FR)
(74) Mandataire: Poulin, Gérard

(56) Documents cités:
- EP-A- 0 540 277
- US-A- 4 968 636
- US-A- 4 997 786
- IBM TECHNICAL DISCLOSURE BULLETIN, vol. 31, no. 8, 1 Janvier 1989, page 114/115 XP000104754 "SELF-ALIGNED QUASI-SEMICONDUCTOR-ON-INSULATOR CMOS STRUCTURE"
- NUCLEAR INSTRUMENTS & METHODS IN PHYSICS RESEARCH, SECTION - B: BEAM INTERACTIONS WITH MATERIALS AND ATOMS, vol. B55, no. 1 / 04, 2 Avril 1991, pages 856-859, XP000230740 BUSSMANN U ET AL: "OXYGEN IMPLANTATION THROUGH PATTERNED MASKS: A METHOD FOR FORMING INSULATED SILICON DEVICE ISLANDS WHILE MAINTAINING A PLANAR WAFER SURFACE"

## Description

### Domaine technique

La présente invention concerne un substrat de type silicium sur isolant, dit SOI (Silicon On Insulator), pour la fabrication de transistors et un procédé de préparation d'un tel substrat.

Les substrats SOI trouvent des applications notamment dans la fabrication de transistors, et de circuits intégrés utilisant ces transistors.

Les substrats conformes à l'invention peuvent être utilisés pour la fabrication de tout type de transistors et en particulier pour des transistors à effet de champ de type métal-oxyde-semiconducteur (MOS), métal-semiconducteur (MESFET), à jonction (JFET), ainsi que pour des transistors bipolaires.

### Etat de la technique antérieure

Les substrats SOI connus comportent une couche superficielle de silicium qui est séparée d'une partie massive de silicium par une couche isolante d'oxyde de silicium.

L'utilisation de substrats SOI permet de réduire dans des proportions importantes les capacités parasites des transistors qui sont fabriqués dans la couche superficielle de silicium. A titre d'exemple, la capacité parasite d'une jonction source-drain d'un transistor à effet de champ réalisé sur un substrat SOI peut être diminuée d'un facteur 6 par rapport à un tel transistor réalisé dans un substrat de silicium massif.

Cependant, le fonctionnement des transistors réalisés sur un substrat SOI, et en particulier des transistors à effet de champ de type MOS, est limité par un phénomène caractéristique des composants à substrat électriquement flottant qui est l'effet "kink".

Cet effet est dû à une accumulation de charges électriques dans le substrat flottant, c'est-à-dire dans la couche mince superficielle. Ces charges proviennent de courants parasites engendrés par un phénomène d'ionisation par impact à la jonction drain-canal des transistors à effet de champ (MOS). Les charges accumulées créent un champ électrique inverse à la jonction drain-source et un "transistor bipolaire" formé par la source (émetteur), le substrat (base) et le drain (collecteur) du transistor à effet de champ peut alors amplifier les courants parasites et provoquer l'apparition de l'effet kink.

Une analyse plus détaillée de l'effet kink peut être trouvée dans le document (1) dont la référence est indiquée à la fin de la présente description.

Le champ électrique inverse facilite le passage d'un courant de perçage. Ainsi, l'effet kink engendre des problèmes de stabilité des caractéristiques et de fiabilité des transistors réalisés sur un substrat SOI. Ces problèmes sont notamment liés à la création d'électrons chauds et de courants de trous qui ne sont pas collectés dans un substrat de type p, ou de trous chauds et de courants d'électrons dans un substrat de type n.

Pour éviter l'apparition de l'effet kink, on limite volontairement les tensions d'alimentation des transistors réalisés sur un substrat SOI. Cette mesure pénalise les performances des transistors et limite le champ d'application des substrats SOI aux dispositifs alimentés en basse tension.

Un but de la présente invention est de proposer un substrat de type SOI et son procédé de réalisation qui permette la fabrication de transistors affranchis de l'effet kink.

Un but est en outre de proposer au substrat compatible avec la réalisation de tout type de transistors et en particulier de transistors de type Métal-Oxyde-Semiconducteur complémentaires (CMOS).

Un but est aussi de proposer une solution simple et efficace pour collecter les courants parasites.

### Exposé de l'invention

Pour atteindre ces buts, l'invention a plus précisément pour objet un procédé de préparation d'un substrat de type silicium sur isolant pour la fabrication de transistors. Conformément à l'invention, le procédé comporte les étapes suivantes :
a) mise en forme de la surface d'un substrat de silicium pour définir une première région et au moins une deuxième région où des transistors peuvent être formés, la deuxième région formant une dépression par rapport à la première région,
b) formation dans les première et deuxième régions d'une couche d'oxyde de silicium, la couche étant enterrée dans la deuxième région, à une profondeur supérieure à l'épaisseur de cette couche (d'oxyde) enterré dans la première région, et recouvrant complètement la surface d'au moins un flanc de transition entre les première et deuxième régions,
c) élimination de la couche d'oxyde de silicium sur le flanc de transition entre les première et deuxième régions,
d) épitaxie d'une couche de silicium sur les première et deuxième régions et sur le flanc de transition entre celles-ci,
e) aplanissement de la couche de silicium épitaxiée dans les première et deuxième régions, avec arrêt sur la couche d'oxyde de silicium de la première région.

Comme l'oxyde de silicium est éliminé sur le flanc de transition entre les première et deuxième régions et que l'on fait croître du silicium par épitaxie à la fois sur ce flanc et sur la deuxième région, il se forme ainsi une connexion entre le silicium se trouvant au-dessus de la couche d'oxyde enterrée de la deuxième région et le silicium se trouvant en-dessous de la couche d'oxyde de la première région.

Cette connexion permet l'écoulement des charges (trous dans un substrat de type p, électrons dans un substrat de type n) de la couche épitaxiée de silicium de la deuxième région, qui constitue la région active des transistors, vers la partie massive du substrat, sous la couche enterrée d'oxyde de silicium.

Dans le cas particulier de dispositifs du type CMOS (MOS complémentaires) la partie massive du substrat peut être délimitée par des caissons dopés. A titre d'exemple, pour des transistors MOS à canal n, le caisson est de type p, et à l'inverse, pour des transistors à canal p, le caisson est de type n. Des prises de contact pliées aux caissons peuvent être prévues pour collecter les courants parasites.

De façon typique, les première et seconde régions peuvent être agencées de façon que chaque deuxième région soit entourée et donc latéralement délimitée par une première région. Ainsi, la couche superficielle de silicium, formée par épitaxie dans la deuxième région, est électriquement isolée par la couche d'oxyde de silicium de la première région, mise à nu lors de l'étape e) du procédé.

Selon une mise en oeuvre particulière du procédé, il est possible, lors de l'étape b) de former la couche d'oxyde de silicium de telle manière qu'elle soit enterrée dans les première et deuxième régions à une profondeur sensiblement égale.

Par ailleurs, conformément à un aspect avantageux de l'invention, le procédé peut être complété par les opérations suivantes :
f) le nettoyage et une oxydation de la surface du substrat, puis
g) une désoxydation partielle de la surface dans les deuxièmes régions.

L'oxydation de la surface du substrat dans la ou les premières régions permet d'épaissir la couche superficielle d'oxyde de silicium qui sert de couche d'arrêt lors de l'aplanissement de la couche de silicium épitaxiée. Un contrôle fin de l'épaisseur du contact latéral entre les secondes régions et le substrat est alors obtenu.

L'oxydation, puis la désoxydation de la surface du substrat dans la ou les deuxièmes régions permet d'amincir et d'ajuster l'épaisseur de la couche superficielle de silicium. Elle permet également de former un bord arrondi entre la couche superficielle de silicium de la deuxième région et la couche superficielle d'oxyde de silicium dans la première région. Un tel bord arrondi permet de contrôler finement les caractéristiques électriques des transistors et la qualité de l'oxyde de grille des transistors MOS.

Conformément à un autre aspect de l'invention, on peut effectuer en outre une implantation d'impuretés de dopage sans la couche d'oxyde de silicium dans la première région et au-dessus de la couche d'oxyde de silicium dans la deuxième région, l'implantation étant effectuée entre les étapes f) et g).

Les impuretés de dopage sont choisies pour former des zones dopées du même type de conductivité que celle de la partie massive du substrat.

Les zones dopées dans les première et seconde régions permettent d'éviter le phénomène de perçage dans la couche de silicium superficielle de la deuxième région, c'est-à-dire la région où sont formés les transistors. Elles permettent également d'améliorer le contact électrique entre cette couche et la partie massive du substrat et d'améliorer l'isolation entre les zones actives.

Selon une mise en oeuvre particulière du procédé de l'invention, la mise en forme de la surface du substrat lors de l'étape a) du procédé peut comporter :
- la formation d'une couche d'oxyde de silicium sur l'ensemble de la surface du substrat,
- la formation d'une couche de nitrure de silicium recouvrant la couche d'oxyde de silicium dans la première région,
- l'oxydation localisée de chaque deuxième région pour y former un pavé d'oxyde de silicium épais,
- l'élimination de la couche de nitrure de silicium, de la couche d'oxyde de silicium et de chaque pavé d'oxyde de silicium

L'élimination du ou des pavés d'oxyde de silicium permet de mettre la ou les deuxièmes régions en retrait par rapport à la surface de la première région, pour former ainsi une ou plusieurs dépressions.

Selon une mise en oeuvre du procédé de l'invention, la couche enterrée d'oxyde de silicium peut être formée par :
- une implantation d'ions oxygène à travers la surface du substrat, et
- un recuit du substrat.
   De façon avantageuse, on peut ajuster la dose et l'énergie des ions implantés pour former la couche d'oxyde de silicium à une profondeur déterminée dans les première et deuxième régions et on ajuste un angle d'implantation par rapport à la surface du substrat pour faire recouvrir complètement le flanc de transistor de la couche d'oxyde de silicium.

Selon un aspect particulier de la mise en oeuvre du procédé, une fine couche d'oxyde de silicium peut être formée par oxydation à la surface du substrat avant l'implantation des ions oxygène de couche d'oxyde enterrée. La fonction essentielle de cette couche d'oxyde fine est de "décanaliser" les ions oxygènes implantés pour former la couche enterrée d'oxyde de silicium.

L'invention concerne également un substrat de type silicium sur isolant pour la fabrication de transistors. Le substrat comprend dans une première région une couche superficielle d'oxyde de silicium recouvrant une partie massive de silicium et, dans au moins une deuxième région où des transistors peuvent être formés entourée par la première région, une couche superficielle de silicium, séparée de la partie massive de silicium par une couche d'oxyde de silicium enterré. Conformément à l'invention, le substrat comporte au moins une prise de contact reliant électriquement la couche superficielle de silicium de la deuxième région et la partie massive de silicium de la première région, la prise de contact étant située entre la couche d'oxyde de silicium enterrée de la deuxième région et la couche d'oxyde de silicium superficielle de la première région.

Un tel substrat est obtenu avec le procédé décrit précédemment.

Le substrat comporte, par exemple, une pluralité de deuxièmes régions entourées de la première région. Les couches superficielles de silicium des deuxièmes régions sont mutuellement isolées en surface par la couche d'oxyde de silicium de la première région.

Des transistors, et en particulier des transistors MOS, peuvent être formés dans les deuxièmes régions. Ces transistors supportent des tensions de polarisation élevées sans souffrir de l'effet kink évoqué ci-dessus. Les porteurs des courants parasites ne s'accumulent pas dans la région active, c'est-à-dire dans la couche superficielle de silicium des deuxièmes régions, mais sont dirigés vers la partie massive du substrat, par l'intermédiaire de la (ou des) prise(s) de contact.

D'autres caractéristiques et avantages de l'invention ressortiront mieux de la description qui va suivre, en référence aux figures des dessins annexés, donnée à titre purement illustratif et non limitatif.

### Brève description des figures

- les figures 1 et 2 sont des coupes schématiques illustrant des étapes de mise en forme de la surface d'un substrat conformément à une mise en oeuvre particulière du procédé de l'invention,
- la figure 3 est une coupe schématique illustrant la formation d'une couche enterrée d'oxyde de silicium dans le substrat montré à la figure 2,
- les figures 4 à 6 sont des coupes schématiques illustrant des étapes de réalisation et de mise en forme d'une zone active sur le substrat montré à la figure 3,
- la figure 7 est une coupe schématique illustrant une étape d'implantation d'impuretés dans le substrat de la figure 6,
- la figure 8 est une coupe schématique illustrant une étape de désoxydation de la surface du substrat de la figure 7,
- les figures 9 et 10 sont des coupes schématiques illustrant la fabrication d'un transistor à effet de champ dans un substrat conforme à l'invention.

### Description détaillée de modes de mise en oeuvre de l'invention

La description qui suit se réfère à la préparation d'un substrat à partir d'une plaque de silicium 10 d'un type de conductivité p. Les étapes peuvent être cependant transposées à une plaque de type n.

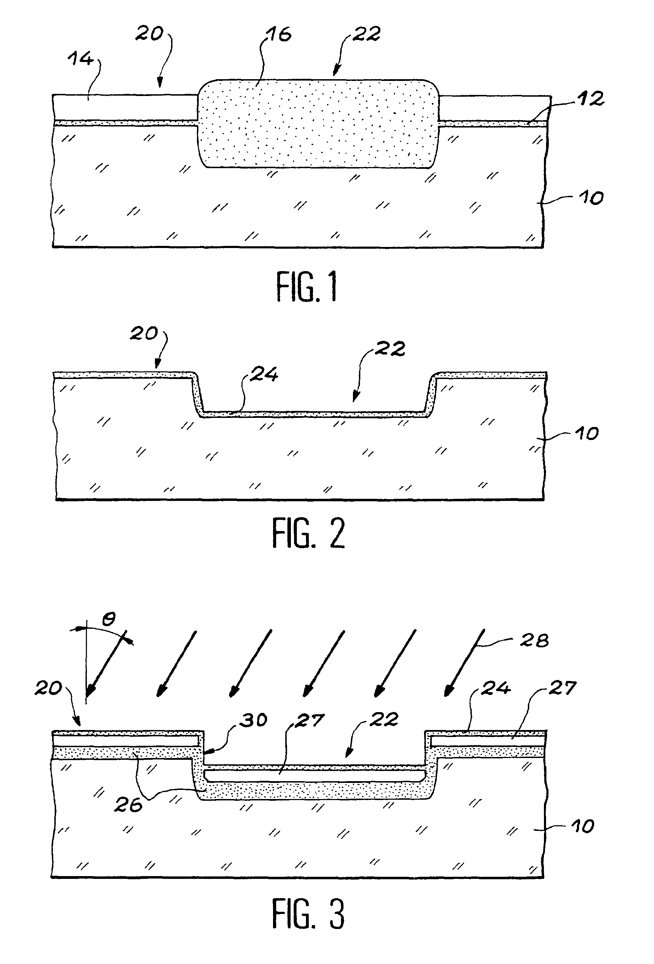

Une couche d'oxyde de silicium 12, dite couche piédestal, est formée par oxydation à la surface de la plaque de silicium 10 et, sur cette couche 12, est formée une couche 14 de nitrure de silicium. La couche 14 de nitrure de silicium est mise en forme par une opération de masquage et de gravure de façon à mettre à nu la couche d'oxyde de silicium 12 dans certaines régions. Une oxydation localisée est alors réalisée dans ces régions pour former des pavés épais 16 d'oxyde de silicium. On obtient ainsi la structure représentée à la figure 1.

Les parties du substrat recouvertes par la couche 14 de nitrure de silicium sont désignées par première région et les parties occupées par les pavés d'oxyde de silicium 16, dont un seul est visible sur la figure 1, sont désignées par deuxièmes régions. Les première et deuxièmes régions sont repérées avec les références 20 et 22 respectivement.

Sur le substrat plusieurs "deuxièmes régions" 22 peuvent être formées. Elles sont alors entourées par la première région. Dans la suite du texte, il n'est cependant fait référence qu'à une seule deuxième région qui est celle visible sur les figures.

Une étape suivante du procédé consiste à éliminer la couche 14 de nitrure de silicium, les pavés 16 d'oxyde de silicium et la couche de piédestal 12, et former sur l'ensemble de la surface du substrat une fine couche d'oxyde de silicium 24. Cette couche est formée par oxydation. On obtient ainsi la structure de la figure 2.

Il apparaît sur la figure 2 qu'après cette étape la deuxième région 22 forme une dépression par rapport à la surface de la première région.

La figure 3 illustre la formation d'une couche enterrée 26 d'oxyde de silicium. Pour former cette couche, des ions oxygène sont implantés dans la plaque de silicium 10 à travers sa surface. On peut noter à ce sujet que la couche d'oxyde de silicium 24 précédemment formée à la surface du substrat permet de décanaliser, c'est-à-dire contrôler avec précision le rayon de projection des ions oxygène implantés de façon à obtenir des zones implantées de concentration en oxygène homogènes.

Après l'implantation un recuit est effectué pour permettre de réaliser et de rendre cohérente la couche 26. La couche 26 délimite alors dans la plaquette de silicium 10 une couche superficielle de silicium 27, qu'elle isole électriquement d'une partie massive de silicium de la plaquette.

L'énergie et la dose des ions implantés sont choisies pour former la couche 26 à une profondeur donnée dans les première et deuxième régions 20, 22. A titre d'exemple, la couche 26 est enterrée à une profondeur comprise entre 10 nm et 200 nm Pour la réalisation d'une couche enterrée d'oxyde de silicium, on peut se reporter au document (2) dont la référence est indiquée à la fin de la présente description.

La couche 26 suit le motif de dénivellation de la surface du substrat. Elle est en effet enterrée à une profondeur égale sous la surface du substrat dans les première et deuxième régions.

Les flèches 28 sur la figure 3 indiquent une orientation du faisceau d'implantation des ions oxygène. Elle forme un angle θ par rapport à la normale au plan du substrat. Ainsi, des ions sont également implantés dans le flanc de transition 30 entre les régions 20 et 22, au moins sur un côté de la deuxième région 22. Pour éviter le déficit d'ions par ombrage des plans, on procède à une rotation des plaquettes de façon à implanter la même dose sur tous les flancs.

La dose d'ions implantée dans le flanc de transition 30 est égale à D.cosθ où D est la dose d'implantation dans les première et deuxième régions.

L'angle d'implantation est choisi suffisamment faible, c'est-à-dire le profil d'oxydation est choisi suffisamment raide, pour que la couche 26, enterrée dans les régions 20, 22, recouvrir complètement la surface du flanc de transition 30. On considère que la couche 26 recouvrir complétement à la surface lorsqu'elle est présente à la surface ou lorsqu'elle est proche de la surface, c'est-à-dire enterrée à une très faible profondeur.

Dans le cas où la couche enterrée 26 n'est pas présente à la surface du flanc 30, mais à une faible profondeur sous la surface, il est accessoirement possible d'effectuer une oxydation pour épaissir la couche d'oxyde de surface 24 jusqu'à ce que celle-ci atteigne la couche enterrée dans la région du flanc de transition 30.

Une étape suivante consiste à effectuer une désoxydation partielle permettant d'éliminer complètement la couche d'oxyde 24 à la surface du substrat et d'éliminer l'oxyde des couches 24 et 26 sur le flanc de transition 30. La couche 27 de silicium, et le silicium de la plaquette 10, sur le flanc 30 sont ainsi mis à nu.

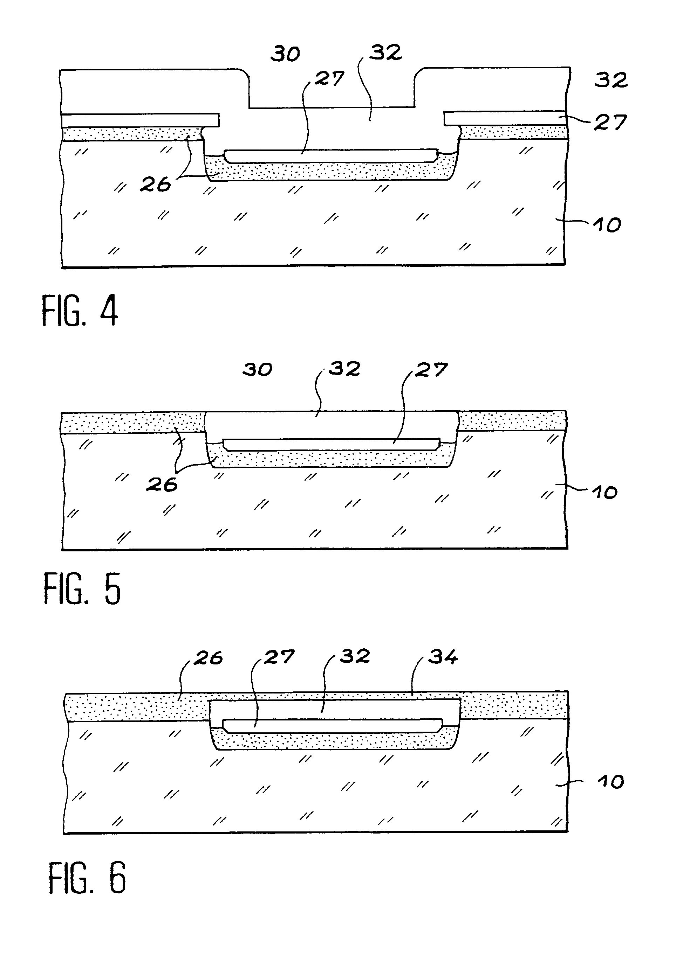

La structure montrée à la figure 4 est obtenue en formant sur le silicium mis à nu une couche de silicium monocristallin 32. Cette couche est formée par épitaxie, préférentiellement à une température comprise entre 850°C et 1300°C, par exemple à 1100°C.

L'épitaxie est contrôlée à partir de la couche superficielle 27 dans les première et deuxième régions 20, 22, et du silicium sur le flanc 30.

De façon avantageuse, l'épitaxie de la couche monocristalline 32 peut être précédée d'un recuit pour éliminer toute contamination résiduelle et pour réduire au minimum les défauts dans la couche de silicium 27.

Une étape suivante consiste à aplanir la couche de silicium avec arrêt sur la couche 26 de la première région 20. L'aplanissement est effectué, par exemple, par un polissage mécanochimique. On obtient la structure représentée à la figure 5.

La couche "enterrée" 26 de la première région 20 est mise à nu et apparaît désormais à la surface du substrat. Dans la deuxième région 22, la couche 26 d'oxyde de silicium reste recouverte par la couche 27 de silicium et par la couche 32 de silicium monocristallin dont l'épaisseur a été réduite au cours de l'aplanissement. La surface du substrat dans les première et deuxième régions se trouve dans un même plan après cette étape.

Une étape suivante consiste en une oxydation de la surface du substrat, comme le montre la figure 6. Cette étape permet, en formant une nouvelle couche d'oxyde de silicium 34, d'épaissir la couche 26 d'oxyde de silicium dans la première région 30 et d'amincir la couche de silicium 32 dans la deuxième région 22.

Une implantation d'impuretés dopantes conduisant à un dopage de même type de conductivité que la plaquette de substrat 10, est effectuée à travers la couche 34. Il s'agit en l'occurrence d'impuretés de bore, conduisant à un dopage de type p.

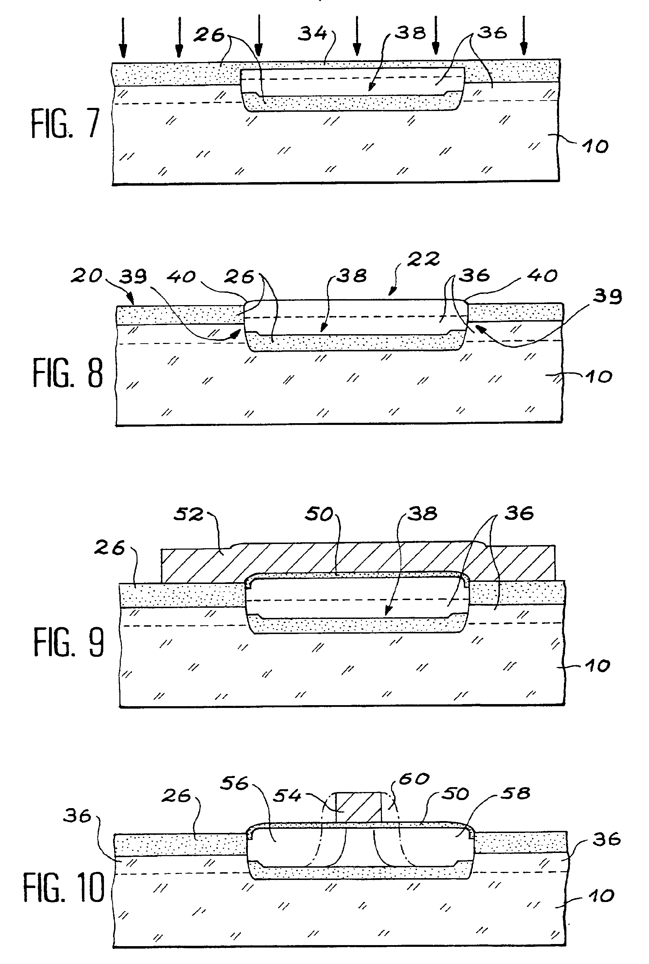

L'implantation, matérialisée par des flèches sur la figure 7, permet de former une zone dopée 36 de type p⁺ qui s'étend sous la couche 26 d'oxyde de silicium dans la première région 20 et au-dessus de la couche 26, dans la deuxième région 22. Dans la deuxième région 22, la zone dopée correspond à la couche 27 et à une partie au moins de la couche 32.

La zone dopée 36 qui passe dans la région du flanc de transition 30 entre les régions 20 et 22 permet d'améliorer une prise de contact électrique entre la partie de la deuxième région située au-dessus de la couche d'oxyde de silicium 26, et désignée par la suite par région "active" 38 et la partie massive de la plaquette de silicium 10.

La zone 36 a aussi un rôle d'anti-perçage dans la région active 38 où sont formés par la suite les transistors.

Une désoxydation partielle suit l'implantation de bore. Elle permet de découvrir la partie active 38 dont la couche 32 a été amincie, tout en préservant une partie, également amincie, de la couche 26 d'oxyde de silicium dans la première région. On obtient la structure représentée à la figure 8.

Lorsque la formation de la couche d'oxyde de silicium est réalisée à une température assez élevée, de l'ordre de 1050°C, on obtient au terme de la désoxydation un bord arrondi entre la partie active 38 et la couche d'oxyde de silicium 26. Ce bord arrondi est repéré avec la référence 40.

Le substrat finalement obtenu comporte une série de caissons avec une structure de type SOI, il s'agit des deuxièmes régions, et isolés mutuellement à la surface par la couche d'oxyde de silicium de la première région.

Une ou plusieurs prises de contact formées à travers les flancs des caissons conformément au procédé décrit ci-dessus, permettent d'évacuer les charges (trous) accumulées dans les régions actives vers la partie massive du substrat et éviter ainsi l'effet kink. Sur la figure 8, les prises de contact sont repérées avec la référence 39.

Les figures 9 et 10 illustrent une utilisation du substrat préparé de la façon décrite ci-dessus pour la réalisation d'un transistor à effet de champ. Les étapes de fabrication de ce transistor sont décrites sommairement ci-dessous.

La figure 9 montre la formation, notamment à la surface de la région active, d'une couche d'oxyde de grille 50 (SiO₂) et le dépôt d'une couche de matériau de grille 52, par exemple de silicium polycristallin.

La couche 52 est ensuite mise en forme par formation d'un masque (non représenté) et par gravure sélective, pour obtenir une grille 54 représentée à la figure 10.

Des régions de source 56 et de drain 58 sont réalisées dans la région active par implantation, en utilisant la grille 54 comme masque.

Les régions 56 et 58 sont de préférence réalisés par une double implantation, par exemple avec des ions conduisant à une conductivité de type opposée à celle de la plaquette massive de silicium du substrat, c'est-à-dire opposée à celle de la région active.

Une première implantation avec une dose légère est suivie par la formation d'espaceurs latéraux 60 sur la grille 54 et par une deuxième implantation à plus forte dose.

Dans le cas illustré, une implantation d'ions conduisant à une conductivité de type n permet de former un transistor à canal n.

Le transistor ou les circuits ainsi réalisés ne présentent pas de base parasite à potentiel flottant. Ceci permet de les affranchir de l'effet kink et par conséquent de polariser le transistor avec des tensions supérieures à celles généralement admises pour les dispositifs MOS sur des substrats de type SOI.

Cette propriété procure notamment l'avantage de pouvoir augmenter les performances des transistors ainsi réalisés.

### DOCUMENTS CITES

*(1)* "Analysis of Kink Characteristics in Silicon-on-Insulator MOSFET's Using Two-Carrier Modeling de KOICHI KATO et al., IEEE Transaction on electron devices vol. E.D. 32, n° 2, February 1985, pp. 458-462
*(2)* Microstructures of silicon implanted with high dose oxygen ions de C. Jaussaud et al. Appl. Phys. Lett. 46(11), 1 June 1985, pp. 1064-1066.

## Revendications

1. Procédé de préparation d'un substrat de type silicium sur isolant pour la fabrication de transistors, le procédé comportant les étapes suivantes :
a) mise en forme de la surface d'un substrat de silicium (10) pour définir une première région (20) et au moins une deuxième région (22) où des transistors peuvent être formés, la deuxième région (22) formant une dépression par rapport à la première région (20),
b) formation dans les première (20) et deuxième (22) régions d'une couche d'oxyde de silicium (26), la couche étant enterrée dans la deuxième région, à une profondeur supérieure à l'épaisseur de la couche d'oxyde enterrée dans la première région, et recouvrant complètement la surface d'au moins un flanc de transition (30) entre les première et deuxième régions,
c) élimination de la couche d'oxyde de silicium (26) sur le flanc (30) de transition entre les première et deuxième régions,
d) épitaxie d'une couche de silicium (32) sur les première et deuxième régions (20, 22) et sur le flanc de transition (30) entre celles-ci,
e) aplanissement de la couche de silicium épitaxiée (32) dans les première et deuxième régions, avec arrêt sur la couche (26) d'oxyde de silicium de la première (20) région.

2. Procédé selon la revendication 1, **caractérisé en ce que** lors de l'étape b) on forme la couche d'oxyde de silicium (26) de manière qu'elle soit enterrée dans les première et deuxième régions à une profondeur sensiblement égale.

3. Procédé selon la revendication 1, **caractérisé en ce qu'**il comporte en outre après l'étape e) :
f) le nettoyage et une oxydation de la surface du substrat, puis
g) une désoxydation partielle de la surface dans la deuxième région (22).

4. Procédé selon la revendication 3, **caractérisé en ce qu'**on effectue en outre une implantation d'impuretés de dopage sous la couche d'oxyde de silicium (26) dans la première région (20) et au-dessus de la couche d'oxyde de silicium (26) dans la deuxième région (22), l'implantation étant effectuée entre les étapes f) et g).

5. Procédé selon la revendication 1,
**caractérisé en ce que** l'étape a) de mise en forme de la surface du substrat comporte :
- la formation d'une couche d'oxyde de silicium (12) sur l'ensemble de la surface du substrat,
- la formation d'une couche de nitrure de silicium (14) recouvrant la couche d'oxyde de silicium (12) dans la première région (20),
- l'oxydation localisée de la deuxième région pour la formation d'un pavé (16) d'oxyde de silicium épais,
- l'élimination de la couche de nitrure de silicium (14), de la couche d'oxyde de silicium (12) et du pavé d'oxyde de silicium (16).

6. Procédé selon la revendication 1, **caractérisé en ce que** la formation de la couche (26) d'oxyde de silicium enterrée lors de l'étape b) comporte :
- une implantation d'ions oxygène à travers la surface du substrat, et
- un recuit du substrat.

7. Procédé selon la revendication 6,
**caractérisé en ce qu'**avant l'implantation des ions oxygène, on réalise, par oxydation, une fine couche (24) d'oxyde de silicium à la surface du substrat, cette couche étant éliminée lors de l'étape c) du procédé.

8. Procédé selon la revendication 6,
**caractérisé en ce qu'**on ajuste la dose de l'énergie des ions implantés pour former la couche (26) d'oxyde de silicium à une profondeur déterminée dans les première et deuxième régions (20, 22) et on ajuste un angle d'implantation par rapport à la surface du substrat pour faire recouvrir complétement le flanc (30) de transition, de la couche d'oxyde de silicium,

9. Procédé selon la revendication 1, **caractérisé en ce qu'**avant l'étape d) d'épitaxie, on effectue un recuit du substrat.

10. Procédé selon la revendication 1, **caractérisé en ce qu'**on effectue l'épitaxie de l'étape d) à une température comprise entre 850°C et 1300°C.

11. Substrat de type silicium sur isolant pour la fabrication de transistors comprenant dans une première région (20) une couche superficielle d'oxyde de silicium (26) recouvrant une partie massive de silicium (10) et, dans au moins une deuxième région (22) où les transistors peuvent être formés, entourée par la première région (20), une couche superficielle de silicium (27, 32), séparée de la partie massive de silicium par une couche d'oxyde de silicium enterrée (26), le substrat comportant au moins une prise de contact (39) reliant électriquement la couche superficielle de silicium (27, 32) de la deuxième région (22) et la partie massive de silicium (10) de la première région (20), la prise de contact (39) étant située entre la couche d'oxyde de silicium (26) enterrée de la deuxième région (22) et la couche d'oxyde de silicium (26) superficielle de la première région.

## Claims

1. Process for the preparation of a substrate of the silicon on insulator type for the production of transistors, said process comprising the following stages:
a) shaping the surface of a silicon substrate (10) in order to define a first region (20) and at least one second region (22) where transistors can be formed, the second region (22) forming a depression relative to the first region (20),
b) formation in the first (20) and second regions (22) of a silicon oxide layer (26), the layer being buried in the second region at a depth greater than the thickness of said buried oxide layer in the first region and completely covering the surface of at least one transition flank (30) between the first and second regions,
c) elimination of the silicon oxide layer (26) on the transition flank (30) between the first and second regions,
d) epitaxying a silicon layer (32) on the first and second regions (20, 22) and on the transition flank (30) between them,
e) levelling the epitaxial silicon layer (32) in the first and second regions, stopping at the silicon oxide layer (26) of the first region (20).

2. Process according to claim 1, **characterized in that** during stage b), formation takes place of a silicon oxide layer (26) in such a way that it is buried in the first and second regions at a substantially equal depth.

3. Process according to claim 1, **characterized in that** it also involves following stage e):
f) cleaning and oxidizing the substrate surface and
g) a partial deoxidation of the surface in the second region (22).

4. Process according to claim 3, **characterized in that** an implantation of doping impurities also takes place beneath the silicon oxide layer (26) in the first region (20) and above the silicon oxide layer (26) in the second region (22), implantation taking place between stages f) and g).

5. Process according to claim 1, **characterized in that** the substrate surface shaping stage a) comprises:
- the formation of a silicon oxide layer (12) on the complete substrate surface,
- the formation of a silicon nitride layer (14) covering the silicon oxide layer (12) in the first region (20),
- localized oxidation of the second region for the formation of a thick silicon oxide block (16),
- elimination of the silicon nitride layer (14) , the silicon oxide layer (12) and the silicon oxide block (16).

6. Process according to claim 1, **characterized in that** the formation of the buried silicon oxide layer (26) during stage b) comprises an implantation of oxygen ions through the substrate surface and the annealing of the substrate.

7. Process according to claim 6, **characterized in that** prior to the implantation of the oxygen ions, by oxidation a fine silicon oxide layer (24) is formed at the surface of the substrate, said layer being eliminated during stage c) of the process.

8. Process according to claim 6, **characterized in that** adjustment takes place to the energy dose of the implanted ions in order to form the silicon oxide layer (26) at a given depth in the first and second regions (20, 22) and adjustment takes place to an implantation angle relative to the substrate surface in order to make the silicon oxide layer completely cover the transition flank (30).

9. Process according to claim 1, **characterized in that** the substrate is annealed prior to the epitaxy stage d).

10. Process according to claim 1, **characterized in that** the epitaxy of stage d) takes place at a temperature between 850 and 1300°C.

11. Substrate of the silicon on insulator type for the production of transistors comprising in a first region (20) a surface silicon oxide layer (26) covering a solid silicon part (10) and, in at least one second region (22) where transistors can be formed surrounded by the first region (20), a silicon surface layer (27, 32) separated from the solid silicon part by a buried silicon oxide layer (26), the substrate comprising at least one contact piece (39) electrically connecting the silicon surface layer (27, 32) of the second region (22) and the solid silicon part (10) of the first region (20), the contact piece (39) being located between the buried silicon oxide layer (26) of the second region (22) and the surface silicon oxide layer (26) of the first region.

## Patentansprüche

1. Verfahren zur Herstellung eines Substrats des Typs Silizium-auf-Isolator zur Herstellung von Transistoren, wobei das Verfahren die folgenden Schritte umfasst:
a) Ausformen der Oberfläche eines Siliziumsubstrats (10) unter Definieren eines ersten Bereichs (20) und wenigstens eines zweiten Bereichs (22), wo Transistoren gebildet werden können, wobei der zweite Bereich (22) eine Vertiefung bezüglich des ersten Bereichs (20) bildet,
b) Bilden einer Siliziumoxidschicht (26) in dem ersten (20) und zweiten (22) Bereich, wobei die Schicht in dem zweiten Bereich in einer größeren Tiefe als der Dicke der in dem ersten Bereich eingebetteten Oxidschicht eingebettet ist und die Oberfläche wenigstens einer Übergangsflanke (30) zwischen dem ersten und zweiten Bereich vollständig bedeckt,
c) Entfernen der Siliziumoxidschicht (26) auf der Übergangsflanke (30) zwischen dem ersten und zweiten Bereich,
d) Epitaxie einer Siliziumschicht (32) auf dem ersten und zweiten Bereich (20, 22) und auf der Übergangsflanke (30) dazwischen,
e) Einebnen der epitaxialen Siliziumschicht (32) in dem ersten und zweiten Bereich, wobei auf der Siliziumoxidschicht (26) des ersten Bereichs (20) angehalten wird.

2. Verfahren gemäß Anspruch 1, **dadurch gekennzeichnet, dass** während des Schritts b) die Siliziumoxidschicht (26) so gebildet wird, dass sie in dem ersten und zweiten Bereich in einer im wesentlichen gleichen Tiefe eingebettet ist.

3. Verfahren gemäß Anspruch 1, **dadurch gekennzeichnet, dass** es außerdem den Schritt e) umfasst:
f) die Reinigung und eine Oxidation der Substratoberfläche und dann
g) eine teilweise Entoxidierung der Oberfläche in dem zweiten Bereich (22).

4. Verfahren gemäß Anspruch 3, **dadurch gekennzeichnet, dass** außerdem eine Implantierung von Dotierungsverunreinigungen unter der Siliziumoxidschicht (26) in dem ersten Bereich (20) und über der Siliziumoxidschicht (26) in dem zweiten Bereich (22) durchgeführt wird, wobei die Implantierung zwischen den Schritten f) und g) durchgeführt wird.

5. Verfahren gemäß Anspruch 1, **dadurch gekennzeichnet, dass** der Schritt a) des Ausformens der Substratoberfläche
- das Bilden einer Siliziumoxidschicht (12) auf der gesamten Substratoberfläche,
- das Bilden einer Siliziumnitridschicht (14), die die Siliziumoxidschicht (12) in dem ersten Bereich (20) bedeckt,
- die örtliche Oxidation des zweiten Bereichs unter Bilden eines dicken Siliziumoxidblocks (16) und
- das Entfernen der Siliziumnitridschicht (14), der Siliziumoxidschicht (12) und des Siliziumoxidblocks (16) umfasst.

6. Verfahren gemäß Anspruch 1, **dadurch gekennzeichnet, dass** das Bilden der eingebetteten Siliziumoxidschicht (26) während des Schritts b)
- eine Implantierung von Sauerstoffionen durch die Substratoberfläche und
- ein Tempern des Substrats umfasst.

7. Verfahren gemäß Anspruch 6, **dadurch gekennzeichnet, dass** vor dem Implantieren der Sauerstoffionen auf der Substratoberfläche durch Oxidation eine dünne Siliziumoxidschicht (24) gebildet wird, wobei diese Schicht während des Verfahrensschritts c) entfernt wird.

8. Verfahren gemäß Anspruch 6, **dadurch gekennzeichnet, dass** die Energiedosis der implantierten Ionen zum Bilden der Siliziumoxidschicht (26) in einer bestimmten Tiefe in dem ersten und zweiten Bereich (20, 22) eingestellt wird und ein Implantationswinkel bezüglich der Substratoberfläche zum vollständigen Bedecken der Übergangsflanke (30) der Siliziumoxidschicht eingestellt wird.

9. Verfahren gemäß Anspruch 1, **dadurch gekennzeichnet, dass** vor dem Epitaxieschritt d) ein Tempern des Substrats durchgeführt wird.

10. Verfahren gemäß Anspruch 1, **dadurch gekennzeichnet, dass** die Epitaxie des Schritts d) bei einer Temperatur zwischen 850 °C und 1300 °C durchgeführt wird.

11. Substrat des Typs Silizium-auf-Isolator zur Herstellung von Transistoren, umfassend in einem ersten Bereich (20) eine Oberflächensiliziumoxidschicht (26), die ein massives Siliziumteil (10) bedeckt und in wenigstens einem zweiten Bereich (22), wo Transistoren gebildet werden können, eine von dem ersten Bereich (20) umgebene Oberflächensiliziumschicht (27, 32), die von dem massiven Siliziumteil durch eine eingebettete Siliziumoxidschicht (26) getrennt ist, wobei das Substrat wenigstens einen Kontakt (39) umfasst, der die Oberflächensiliziumschicht (27, 32) des zweiten Bereichs (22) und das massive Siliziumteil (10) des ersten Bereichs (20) trennt, und sich der Kontakt (39) zwischen der eingebetteten Siliziumoxidschicht (26) des zweiten Bereichs (22) und der Oberflächensiliziumoxidschicht (26) des ersten Bereichs befindet.
